# EUROPEAN PATENT SPECIFICATION

(11) **EP 4 269 533 B1**
(45) Date of publication and mention of the grant of the patent: **19.08.2026**
(21) Application number: 21911042.6
(22) Date of filing: 24.12.2021
(51) Int. Cl.: C09K 11/02, C09K 11/88, C09K 11/62, H10H 20/851

(54) **QUANTUM DOT PRODUCTION METHOD AND QUANTUM DOTS**
QUANTENPUNKTHERSTELLUNGSVERFAHREN UND QUANTENPUNKTE
PROCÉDÉ DE PRODUCTION DE POINTS QUANTIQUES ET POINTS QUANTIQUES

(30) Priority: 25.12.2020 JP 2020217158; 26.03.2021 JP 2021053070
(43) Date of publication of application: 01.11.2023
(73) Proprietor: TOPPAN INC., Tokyo 110-0016 (JP)
(72) Inventor: MISHIMA Akio, Chikushino-shi, Fukuoka, 818-0003 (JP); NIKATA Soichiro, Chikushino-shi, Fukuoka, 818-0003 (JP); KALOUSEK Vit, Chikushino-shi, Fukuoka, 818-0003 (JP); SHIMASAKI Toshiaki, Chikushino-shi, Fukuoka, 818-0003 (JP); OGURA Yuko, Tokyo, 110-0016 (JP); TAKASAKI Mikihiro, Tokyo, 110-0016 (JP); UEDA Shogo, Chikushino-shi, Fukuoka, 818-0003 (JP); ASHIMURA Yuya, Chikushino-shi, Fukuoka, 818-0003 (JP)
(74) Representative: SSM Sandmair
(86) International application number: PCT/JP2021/048136
(87) International publication number: WO 2022/138905

(56) References cited:
- JP-A- 2014 002 980
- JP-A- 2017 501 571
- JP-A- 2020 041 124
- US-A1- 2015 240 153
- US-A1- 2020 006 601
- TIANYU BAI, XUEMIN WANG, YANYU DONG, SHANGHUA XING, ZHAN SHI, SHOUHUA FENG: "One-Pot Synthesis of High-Quality AgGaS 2 /ZnS-based Photoluminescent Nanocrystals with Widely Tunable Band Gap", INORGANIC CHEMISTRY, AMERICAN CHEMICAL SOCIETY, EASTON , US, vol. 59, no. 9, 4 May 2020 (2020-05-04), Easton , US , pages 5975 - 5982, XP055729507, ISSN: 0020-1669, DOI: 10.1021/acs.inorgchem.9b03768

## Description

### Technical Field

The present invention relates to a method for manufacturing quantum dots having a core/shell structure, and a quantum dot.

### Background Art

The quantum dots are inorganic nanoparticles composed of about several thousands to several tens of thousands of atoms and having a particle size of about several nm to ten-odd nm. The quantum dot emits fluorescence, and is also called a fluorescent nanoparticle because its size is a nano-order size, a semiconductor nanoparticle because its composition is derived from a semiconductor material, or a nanocrystal because its structure has a specific crystal structure.

The quantum dot is composed of a metal atom having a positive charge and a non-metal or metalloid atom having a negative charge, and the metal atom and the metalloid atom are bonded by an ionic bond or a covalent bond. The ionic bonding property of the bond depends on a combination of properties of the metal atom and the semi-metal atom.

The emission wavelength of the quantum dot can be variously changed depending on the particle size of the particle and the composition thereof. Examples of the quantum dot performance include a fluorescence quantum yield (QY) and a fluorescence full width at half maximum (FWHM) .

One of the performances of quantum dots is photoluminescence. The quantum dot can absorb a wavelength in a specific wavelength region, convert the wavelength into a wavelength in a specific region, and emit light. In addition, the absorption wavelength and the emission wavelength can be controlled by the structure, composition, and size of the quantum dot, and can be used for various applications by taking advantage of the characteristics thereof.

For example, when a quantum dot is used as a wavelength conversion material in a visible light region, one of the characteristics thereof is that a range of representable colors is wide, that is, a color gamut is increased. In realizing a high color gamut by the wavelength conversion member in the visible light region using the quantum dots, important optical characteristics are a fluorescence quantum yield and a fluorescence full width at half maximum.

High-efficiency quantum dots that have been used conventionally mainly contain cadmium (Cd). The quantum dot containing Cd has an advantage that a fluorescence quantum yield is high and a fluorescence full width at half maximum is narrow. On the other hand, there are regulations on the use of Cd in various countries due to the toxicity of Cd, and this has been a major barrier to practical use.

On the other hand, many quantum dots not containing Cd have been studied to be developed. For example, the following Patent Literatures describe AIS or AIGS-based quantum dots or AISe or AIGSe-based quantum dots containing Ag, In, S, or Ag, In, Ga, S, or Ag, In, Se, or Ag, In, Ga, and Se.

### Citation List

### Patent Literature

Patent Literature 1: JP 2017-025201 A
Patent Literature 2: JP 2018-039971 A
Patent Literature 3: JP 2018-044142 A
Patent Literature 4: JP 2018-141141 A
Patent Literature 5: WO 2018/159699 A

### Non Patent Literature

Non Patent Literature 1: NPG Asia Materials volume 10. 2018, pp713-726
Non Patent Literature 2: ACS Publications 2018,10,49,41844-41855
Non Patent Literature 3: ACS Publications Nano Mater. 2020, 3, 3275-3287
Non Patent Literature 4: The Journal of Physical Chemistry Letters; Ligand-Induced Luminescence Transformation in AgInS2 Nanoparticles: From Defect Emission to Band-Edge Emission US 2015/0240153 A1 discloses nano-crystalline core and nano-crystalline shell pairings having group I-III-VI material nano-crystalline cores, and methods of fabricating nano-crystalline core and nano-crystalline shell pairings having group I-III-VI material nano-crystalline cores. In an example, a semiconductor structure includes a nano-crystalline core composed of a group I-III-VI semiconductor material. A nano-crystalline shell composed of a second, different, semiconductor material at least partially surrounds the nano-crystalline core. In one specific example, the nano-crystalline core/nano-crystalline shell pairing has a photoluminescence quantum yield (PLQY) of greater than 60%. In another specific example, the nano-crystalline core/nano-crystalline shell pairing is a Type I hetero-structure. US 2020/0006601 A1 discloses semiconductor nanoparticles including Ag, In, Ga, and S. In the semiconductor nanoparticles, a ratio of a number of Ga atoms to a total number of In and Ga atoms is 0.95 or less. The semiconductor nanoparticles emit light having an emission peak with a wavelength in a range of from 500 nm to less than 590 nm, and a half bandwidth of 70 nm or less, and have an average particle diameter of 10 nm or less.
Tianyu Bai, Xuemin Wang, Yanyu Dong,Shanghua Xing, Zhan Shi, Shouhua Feng: "One-Pot Synthesis of High-Quality AgGaS 2 /ZnS-based Photoluminescent Nanocrystals with Widely Tunable Band Gap", Inorganic Chemistry, American Chemical Society, Easton, US, vol. 59, no. 9, 4 May 2020 (2020-05-04), pages 5975-5982, XP055729507, Easton, US discloses a facile colloidal method to synthesize the high-quality AgGaS₂ nanocrystals (NCs) within 2 min via exploiting the high-reactivity S precursor and then extend this synthetic strategy to the preparation of AgGaS₂/ZnS core-shell NCs by a one-pot method without prior purification of AgGaS₂ core. The as-synthesized samples were structurally characterized to confrim the formation of AgGaS₂/ZnS core-shell NCs. The energy band gap of the AgGaS₂/ZnS NCs can be effectively tunable from 2.98 to 2.83 eV by the control of their nonstoichiometry and further continuously decreases to 1.90 eV by the preparation of alloyed AgGaₓIn₁₋ₓS₂/ZnS NCs (1 ≤ x ≤ 0). Benefitting from the efficient band gap modulations, the photoluminescence (PL) colors of the AgGaS₂-based NCs can cover almost the whole visible region from blue (460 nm) to red (671 nm). Our work demonstrates the one-pot synthesis of AgGaS₂/ZnS core-shell NCs and their band gap engineering, which is of crucial in scalability toward industrial application and in tailoring optical characteristics of I-III-VI₂ materials.

### Summary of Invention

### Technical Problem

By the way, when Zn is used for AgGaS or AgInGaS, defect emission occurs due to a difference in valence (Zn is divalent, Ag is monovalent, and Ga or In is trivalent), and the fluorescence full width at half maximum tends to increase.

In addition, even when Zn is post-added to AgGaS or AgInGaS so as not to contain Zn, the cationic species easily diffuse into the particles. Therefore, Zn was easily diffused into the core, resulting in defect emission.

Therefore, the present invention has been made in view of such a point, and an object of the present invention is to provide a method for manufacturing quantum dots capable of containing a large amount of Zn on the surface, and a quantum dot.

### Solution to Problem

The invention is defined by the subject-matter of claims 1 and 6. The dependent claims relate to preferred embodiments of the present invention.

### Advantageous Effects of Invention

According to the method for manufacturing quantum dots of the present invention, the surface of a core containing at least Ag, Ga, and S or Ag, Ga, and Se can be coated with a shell containing a large amount of Zn, and a quantum dot having band edge emission with a fluorescence full width at half maximum of 35 nm or less can be accurately manufactured. According to the quantum dot of the present invention, a large amount of Zn can be contained in the surface while maintaining band edge emission. As described above, since the surface of the core can be appropriately coated with the shell having a large amount of Zn, the stability of the fluorescence characteristic can be improved, and a high fluorescence quantum yield can be maintained.

### Brief Description of Drawings

Fig. 1 is a schematic diagram of a quantum dot in an embodiment of the present invention.
Fig. 2 is a schematic diagram of an LED device using quantum dots according to an embodiment of the present invention.
Fig. 3 is a longitudinal sectional view of a display device using the LED device according to the embodiment of the present invention.
Fig. 4 is a conceptual diagram showing a step of manufacturing the quantum dot of the embodiment of the present invention.
Fig. 5 is an X-ray diffraction (XRD spectrum) spectrum in Example 1.
Fig. 6 shows photoluminescence (PL) spectra in Examples 1 and 2.
Fig. 7(a) is a photograph of analysis results (Se + S and Ag + Zn) of TEM-EDX in Example 1, and Fig. 7(b) is a partial schematic view of Fig. 7(a).
Fig. 8(a) is a photograph of an analysis result of high-resolution STEM in Example 2, and Fig. 8(b) is a partial schematic view of Fig. 8(a).
Fig. 9(a) is a photograph of an analysis result (Ag + Zn) of TEM-EDX in Example 2, and Fig. 9(b) is a partial schematic view of Fig. 9(a).
Fig. 10(a) is a photograph of the analysis result (Zn) of TEM-EDX in Example 1 and Comparative Example, and Fig. 10(b) is a partial schematic view of Fig. 10(a).
Fig. 11 shows photoluminescence (PL) spectra in Example 3 and Comparative Example 2.
Fig. 12(a) is a photograph of the analysis result (Ag + Ga) of TEM-EDX in the core of Example 3. Fig. 12(b) is the photoluminescence (PL) spectrum at the core of Example 3. Fig. 12(c)is a partial schematic diagram of Fig. 12(a).

### Description of Embodiments

Hereinafter, an embodiment (Hereinafter, it is abbreviated as "embodiment") of the present invention will be described in detail. The present invention is not limited to the following embodiments, and various modifications can be made within the scope of the gist of the present invention. In the present specification, the expression "to" includes the lower limit value and the upper limit value.

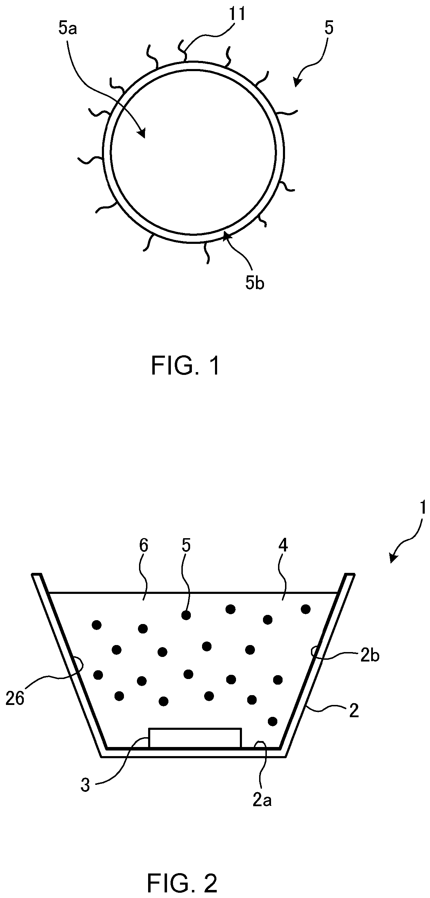

Fig. 1 is a schematic diagram of a quantum dot in the present embodiment. Quantum dots 5 shown in Fig. 1A are nanocrystals not containing Cd.

In the present embodiment, the quantum dot 5 is a core/shell structure of a core 5a and a shell 5b coating the surface of the core 5a. The core 5a is preferably a nanocrystal containing at least silver (Ag), gallium (Ga), and sulfur (S) or Ag, Ga, and selenium (Se). However, it is preferable that the core 5a does not contain cadmium (Cd) or In.

The core 5a can also contain copper (Cu) or indium (In). The Ga/In ratio is preferably 5 or more, and more preferably 10 or more. It is still more preferable that the Ga/In ratio is 30 or more.

Similarly to the core 5a, the shell 5b with which the surface of the core 5a is coated preferably does not contain cadmium (Cd) or indium (In). In the present embodiment, the shell 5b contains a large amount of zinc (Zn). Specifically, the shell 5b is preferably made of zinc sulfide (ZnS), zinc selenide (ZnSe), gallium zinc selenide (ZnGa₂Se₄), or gallium zinc sulfide (ZnGa₂S₄). Among them, ZnS is preferable. The shell 5b may be in a state of being solid-solved in the surface of the core 5a.

The shell 5b can also contain copper (Cu) or indium (In). Specifically, the shell 5b preferably includes copper sulfide (CuS), copper selenide (CuSe), indium sulfide (In₂S₃), indium selenide (In₂Se₃), indium zinc selenide (ZnIn₂Se₄), indium zinc sulfide (ZnIn₂S₄), indium copper sulfide (CuIn₂S₄), and indium copper selenide (CuIn₂Se₄). The shell 5b may be in a state of being solid-solved in the surface of the core 5a.

The quantum dot 5 of the present embodiment can appropriately coat the surface of the core 5a of AgGaSe or AgGaS with the shell 5b such as ZnS or ZnGa₂S₄. In the present embodiment, diffusion of Ag contained in the core 5a into the shell 5b is suppressed. When the core 5a contains Se, Se contained in the core 5a and S contained in the shell 5b can be appropriately separated. In addition, diffusion of Zn contained in the shell 5b into the core 5a can be suppressed.

In the present embodiment, gallium (Ga) may be further contained in the shell 5b, or GaS or GaSe may be interposed between the core 5a and the shell 5b as the first layer of the shell.

Here, the "nanocrystal" refers to nanoparticles having a particle size of about several nm to several tens of nm. In the present embodiment, a large number of quantum dots 5 can be produced with a substantially uniform particle size.

In the present embodiment, the amount of Zn present on the surface of the quantum dot 5 can be increased. Specifically, the Zn amount has a weight ratio of 5% or more, preferably 10% or more, and more preferably 20% or more, with respect to the entire quantum dots 5. Although the upper limit value is not limited, for example, the upper limit value is about 40%.

The Ga/In ratio of the entire quantum dots 5 is preferably 10 or more, and more preferably 30 or more. It is still more preferable that the Ga/In ratio is 50 or more. Furthermore, the Ga/Zn ratio is preferably 1 or less. It is more preferably 0.5 or less.

As shown in Fig. 1, a large number of organic ligands 11 are preferably coordinated to the surface of the quantum dot 5. In this way, aggregation of the quantum dots 5 can be suppressed, and desired optical characteristics can be exhibited. The ligand that can be used in the reaction is not particularly limited, and representative examples thereof include the following ligands.
(1) Aliphatic primary amine system
   Oleylamine: C₁₈H₃₅NH₂, stearyl (octadecyl) amine: C₁₈H₃₇NH₂, dodecyl (lauryl) amine: C₁₂H₂₅NH₂, decylamine: C₁₀H₂₁NH₂, octylamine: C₈H₁₇NH₂
(2) Fatty acid system
   Oleic acid: C₁₇H₃₃COOH, Stearic acid: C₁₇H₃₅COOH, Palmitic acid: C₁₅H₃₁COOH, Myristic acid: C₁₃H₂₇COOH, Lauric acid: C₁₁H₂₃COOH, Decanoic acid: C₉H₁₉COOH, Octanoic acid: C₇H₁₅COOH
(3) Thiol system
   Octadecanethiol: C₁₈H₃₇SH, hexadecanethiol: C₁₆H₃₃SH, tetradecanethiol: C₁₄H₂₉SH, dodecanethiol: C₁₂H₂₅SH, decanethiol: C₁₀H₂₁SH, octanethiol: C₈H₁₇SH
(4) Phosphine system
   Trioctylphosphine: (C₈H₁₇)₃P, triphenylphosphine: (C₆H₅)₃P, tributylphosphine: (C₄H₉)₃P
(5) Phosphine oxide system
   Trioctylphosphine oxide: (C₈H₁₇)₃P = O, triphenylphosphine oxide: (C₆H₅)₃P = O, tributylphosphine oxide: (C₄H₉)₃P = O
(6) Alcohol system
   Oleyl alcohol: C₁₈H₃₆O

In addition, it is preferable that the inorganic ligand is coordinated together with the organic ligand. In this way, quantum dot surface defects can be further suppressed, and higher optical characteristics can be exhibited. The ligand is not particularly limited, but a halogen such as F, Cl, Br, or I is a typical example.

Next, a method for manufacturing quantum dots will be described. An object of the present embodiment is to provide a method for manufacturing quantum dots capable of stabilizing the emission characteristics by increasing the amount of Zn contained in the shell 5b while exhibiting band edge emission. In the present embodiment, the band edge emission can be performed only with the core 5a. This point will be described later.

Conventionally, as an example of a method for manufacturing quantum dots, for example, a surface of AgGaSe is coated with a shell containing Se, and then Zn is added. However, according to the present embodiment, the amount of Zn on the core surface can be increased by the following method. That is, the method for manufacturing quantum dots of the present embodiment has the following features.
(1) The method includes a step of producing a core 5a containing at least Ag, Ga, and S or Ag, Ga, and Se, and a step of coating the surface of the core 5a with the shell 5b.
(2) In the step of coating with the shell 5b, the surface of the core 5a is coated with GaS, and then Zn is added. Here, the valence of GaS is not considered. That is, GaₓS_{y} (x = 1 to 2, y = 1 to 6), for example, GaS or Ga₂S₃. In addition, even in a case where the core surface is coated with GaSe, it can be represented by GaₓSe_{y} (x = 1 to 2, y = 1 to 6), and is represented by, for example, GaSe or Ga₂Se₃. The "addition of Zn" includes the addition of Zn alone and the addition of ZnS, ZnSe, ZnGa₂Se₄, or ZnGa₂S₄.

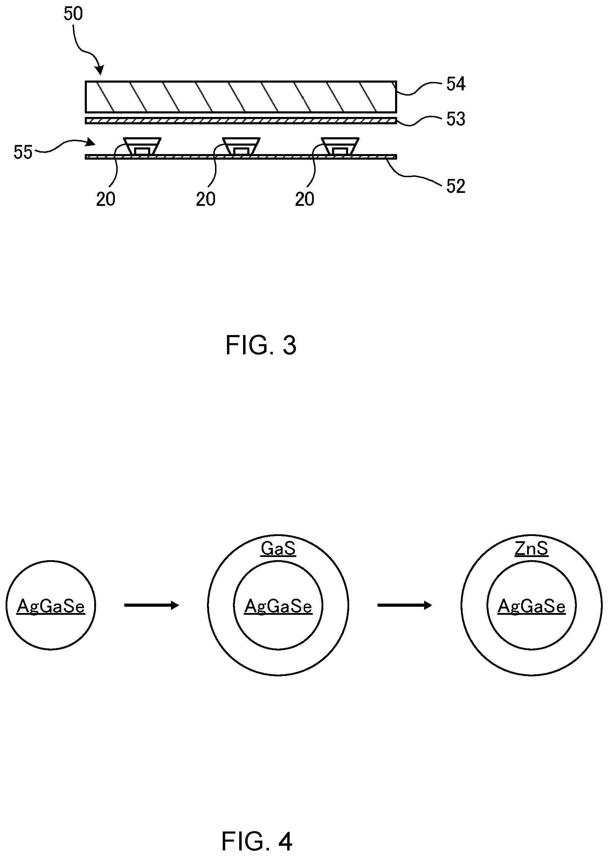

In the present embodiment, it is preferable that the surface of the core 5a is coated with GaS and then coated with ZnS. Fig. 4 is a conceptual diagram of a manufacturing step of the quantum dot 5 of the present embodiment. As shown in the left diagram of Fig. 4, after the AgGaSe core is produced, the surface of the AgGaSe core is coated with a GaS shell as shown in the center diagram of Fig. 4. Zn is then post-added to obtain a ZnS shell as shown in the right diagram of Fig 4. As shown in the center diagram of Fig. 4, the GaS shell with which the surface of the AgGaSe core is coated is an important shell for preventing Zn from diffusing into the core 5a at the next Zn addition. It is considered that the amount of Ga remaining in the shell after Zn addition is reduced by, for example, releasing Ga from the shell to the outside through a dissolution or washing step, but Ga may be contained in the shell. That is, the shell may be ZnGa₂S₄. Alternatively, a GaS shell may be interposed between the AgGaSe core and the ZnS shell. That is, the shell may have a two-layer structure of GaS/ZnS.

Alternatively, in the present embodiment, it is preferable that Ga and Zn of GaS are subjected to cation exchange to coat with the ZnS shell. That is, the particle size of AgGaSe/GaS in the center diagram of Fig. 4 and the particle size of AgGaS/ZnS in the right diagram of Fig. 4 were almost the same as confirmed by the analysis result of TEM-EDX. From this, it can be presumed that coating of the ZnS shell with which the surface of AgGaS is coated is performed by cation exchange. Thus, by cation exchange or anion solid solution, it is possible to synthesize quantum dots having a core/shell structure with a large amount of Zn on the surface without changing the particle size.

In the conventional manufacturing method, even if the ZnS coating is performed, Zn is immediately diffused into the core to cause defect emission, and a large amount of ZnS coating cannot be performed. On the other hand, in the present embodiment, the crystallinity of ZnS obtained by post-adding Zn after GaS coating could be confirmed. At the time of shell coating, for example, oleylamine is conventionally used, but it is considered that oleylamine becomes a ligand that hinders shell coating. Indeed, it has been found that performing a GaS coating operation in which the XRD is not shifted leads to defect emission when Zn is added. On the other hand, in the present embodiment, for example, non-amine-based DDT (dodecanethiol) is used at the time of shell coating. Besides DDT, ODE can also be used. However, oleylamine can also be included as long as it is not the main solvent. As shown in the experimental results described later, it is known that XRD is shifted in the GaS coating process after DDT is used. As described above, in the present embodiment, by using GaS in a DDT (or ODE) solvent, it is possible to perform coating without Ag diffusing to the surface.

According to the method for manufacturing the quantum dots 5 of the present embodiment described above, diffusion of Ag contained in the core 5a into the shell can be suppressed, and further, in a form in which Se contained in the core 5a is contained, Se in the core 5a and S contained in the shell 5b can be appropriately separated. Then, according to the method for manufacturing the quantum dots 5 of the present embodiment, the amount of Zn contained in the shell 5b can be increased. Although not particularly limited, the amount of Zn in the quantum dots 5 can be adjusted to 5% or more, preferably 10% or more, and more preferably 20% or more in a weight ratio.

A method for manufacturing quantum dots will be specifically described. First, in the present embodiment, an organic silver compound, an organic gallium compound, and selenium are synthesized by heating in one pot.

At this time, the reaction temperature is set to a range of 100°C or higher and 320°C or lower to synthesize AgGaSe. The reaction temperature is preferably 280°C or lower, which is a lower temperature.

In the present embodiment, an organic silver compound or an inorganic silver compound is used as a raw material of Ag. Although not particularly limited, for example, silver acetate: AgOAc, silver nitrate: AgNO₃, silver chloride: AgCl, silver bromide: AgBr, silver iodide: AgI as the halide, silver diethyldithiocarbamate: Ag(SC( = S)N(C₂H₅)₂), silver dimethyldithiocarbamate: Ag(SC( = S)N(CH₃)₂) as the carbamate, and the like can be used.

In addition, in the present embodiment, the above-described Ag raw material may be directly added to the reaction solution, but a solution obtained by dissolving the Ag raw material in an organic solvent in advance to have a constant concentration may be used as the Ag raw material solution.

In the present embodiment, an organic gallium compound or an inorganic gallium compound is used as a raw material of Ga. Although not particularly limited, for example, gallium acetate: Ga(OAc)₃, gallium nitrate: GaNO₃, gallium acetylacetonate: Ga(acac)₃, can be used, gallium chloride: GaCl₃, gallium bromide: GaBr₃, or gallium iodide: Ga₂I₃ can be used as a halide, gallium diethyldithiocarbamate: Ga[(SC( = S)N(C₂H₅)₂]₃ as can be used a carbamate, and the like can be used.

In addition, in the present embodiment, the Ga raw material may be directly added to the reaction solution, but may be dissolved in an organic solvent in advance to form a solution having a constant concentration, and then used as the Ga raw material solution.

For example, trioctylphosphine selenide: (C8H17)3P = Se in which selenium is dissolved in trioctylphosphine, tributylphosphine selenide: (C4H9)3P = Se in which selenium is dissolved in tributylphosphine, or a solution obtained by dissolving selenium in a high boiling point solvent which is a long chain hydrocarbon such as octadecene can be used. When AgGaSe is synthesized, selenium raw material species greatly contribute to fluorescence characteristics. In particular, a solution (Se-OLAm/DDT) in which Se is dissolved in a mixture of oleylamine and dodecanethiol shows good emission characteristics. In a normal chalcopyrite-based quantum dot, two types of emission of a PL spectrum considered to be band edge emission and a PL spectrum considered to be defect emission can be confirmed at the initial stage of emission, and the emission intensity ratio is most often 10 or less for band edge emission/defect emission. Thereafter, as the reaction further progresses, the intensity of defect emission gradually decreases, and accordingly, the intensity of band edge emission also increases in many cases. However, when Se-DDT/OLAm is used as the Se source as in the present embodiment, a single peak is observed from the initial stage of emission, the band edge emission/defect emission is 10 or more, and a peak considered to be defect emission is hardly observed. The fluorescence full width at half maximum is 30 nm or less. The fluorescence lifetime is as short as 20 ns or less before reaching 1/e, and only a peak that is not defect emission can be confirmed at the initial stage of emission.

Next, in the present embodiment, the surface of the core 5a made of nanocrystals is coated with the shell 5b, whereby the fluorescence quantum yield can be further increased. As described above, in the present embodiment, first, the surface of the core is coated with GaS, and then Zn is added. Here, the Ga source is as described above.

In the present embodiment, an organic sulfur compound such as thiol can be used as a raw material of S. Examples thereof include octadecanethiol: C₁₈H₃₇SH, hexane decanethiol: C₁₆H₃₃SH, tetradecanethiol: C₁₄H₂₉SH, dodecanethiol: C₁₂H₂₅SH, decanethiol: C₁₃H₂₁SH, and octanethiol: C₈H₁₇SH. In addition, an S-ODE raw material in which sulfur is dissolved in octadecene: ODE, an S-DDT raw material in which sulfur is dissolved in dodecanethiol, a disulfide-based or thiuram-based S raw material, and S-OLAm/DDT in which S is dissolved in oleylamine and dodecanethiol can be used. In particular, the S raw material is not limited.

In addition, an organozinc compound or an inorganic zinc compound is used as the Zn source. The organozinc compound and the inorganic zinc compound are raw materials which are stable and easily handled even in the air. The present raw material can also be used as a ligand. The structures of the organozinc compound and the inorganic zinc compound are not particularly limited, but for example, the following organozinc compound and inorganic zinc compound can be used. zinc acetate: Zn(OAc)₂ or zinc nitrate: Zn(NO₃)₂ can be used as acetate salts, zinc stearate: Zn(OC( = O)C₁₇H₃₅)₂, zinc oleate: Zn(OC( = O)C₁₇H₃₃)₂, zinc palmitate: Zn(OC( = O)C₁₅H₃₁)₂, zinc myristate: Zn(OC( = O)C₁₃H₂₇)₂, zinc dodecanoate: Zn(OC( = O)C₁₁H₂₃)₂, or zinc acetylacetonate: Zn(acac)₂ can be used as fatty acid salts, zinc chloride: ZnCl₂, zinc bromide: ZnBr₂, or zinc iodide: ZnI₂ can be used as halides, and zinc diethyldithiocarbamate: Zn(SC( = S)N(C₂H₅)₂)₂, zinc dimethyldithiocarbamate: Zn(SC( = S)N(CH₃)₂)₂, zinc dibutyldithiocarbamate: Zn(SC( = S)N(C₄H₉)₂)₂, or the like can be used as zinc carbamates.

In the present embodiment, quantum dots can be obtained in one pot without isolating and purifying the precursor.

In addition, after having a core/shell structure, purification is performed with a specific solvent. For example, trioctylphosphine (TOP) can be used, but a high fluorescence quantum yield can be obtained without containing TOP. In addition, TOP can be contained as a ligand. In the present embodiment, the synthesized reaction solution may be centrifuged.

In the above-described method for manufacturing quantum dots, an AgGaSe core is produced, but a core containing at least Ag, Ga, and S can be produced. The Ag raw material, the Ga raw material, and the S raw material at this time are as described above. In addition, Cu or In can be included in the core. Furthermore, regarding the shell, in a case where it is desired to finally obtain ZnSe or ZnGa₂Se₄, it is considered that the shell of the first layer is preferably GaSe. However, after GaSe coating, coating with ZnS or ZnGaS is also possible. In addition, in a case where the shell of the first layer is GaS, it is considered that a shell containing ZnS, ZnGa₂S₄, or both can be finally obtained. However, coating with ZnSe or ZnGaSe can be performed after GaS coating.

In the present embodiment, coating with the ZnS shell can be performed by cation exchange between Ga and Zn after coating with GaS.

In the method for manufacturing quantum dots of the present embodiment, a core is formed, and then a predetermined element is post-added to synthesize a shell. At this time, in the early stage of the reaction for producing the core, In can be contained, but it is preferable that In is not contained. In this way, it is possible to obtain good emission characteristics.

In the present embodiment, when Zn is contained in the quantum dot, it is preferable to add Zn with attention to the following points. The first point is that Zn is not added during the initial reaction but added in the final step. This is because when Zn is contained inside the particle, defect emission is dominant or only defect emission may be confirmed. Therefore, it is an object to react only the particle surface by adding Zn in the final step. The second point is that Zn is added at low temperature. Here, the low temperature means about 150 to 250°C. When the temperature at the time of adding Zn is high, Zn reacts up to the inside of the particle, and thus defect emission is likely to occur. Therefore, in order to keep the reaction up to the particle surface, it is preferable to react only the particle surface at a low temperature.

In addition, in the present embodiment, it is preferable to use gallium acetylacetonate: Ga(acac)₃ as the Ga raw material rather than gallium chloride when synthesizing AgGaSe because favorable emission characteristics can be obtained.

The Se raw material is preferably Se-OLAm/DDT. In this way, it is possible to effectively suppress defect emission.

Furthermore, by adding TOP to the separated quantum dots, the fluorescence quantum yield can be further improved. However, it is not essential to add TOP.

As described above, according to the method for manufacturing quantum dots of the present embodiment, the surface of the core containing at least Ag, Ga, and S or Ag, Ga, and Se can be appropriately coated with the shell containing a large amount of Zn. In this way, quantum dots having band edge emission with a fluorescence full width at half maximum of 35 nm or less can be manufactured with high accuracy, and mass production can be realized. In the present embodiment, the core can be appropriately coated with a shell made of ZnS, whereby the stability of fluorescence characteristics can be improved, and a high fluorescence quantum yield, specifically, a fluorescence quantum yield of 70% or more can be obtained.

The band edge emission will be described. In the present embodiment, band edge emission is possible not only in the core/shell structure but also in the single core. Here, in the invention described in Patent Literature, it is assumed that band edge emission is not confirmed particularly for the quantum dots of Groups 11 to 13 to 16, and band edge emission is not performed by the single core. In each Patent Literature, a predetermined shell operation is performed to obtain band edge emission.

In addition, in the method defined as shell coating in each of Patent Literatures and Non-Patent Literatures, it can be assumed that the core performs band edge emission by performing surface treatment of the core by shell coating operation instead of shell coating. In the quantum dot of the present embodiment, the core that performs band edge emission is realized without performing the surface treatment. In addition, the quantum dot realized by the present embodiment is a quantum dot having the same features as the conventional core/shell structure.

The core/shell structure of the conventional quantum dot indicates a quantum dot in which the entire particle separated by an element having clearly different core and shell compositions is crystallized. Another feature is that an XRD peak position different from that of the core is exhibited by shell coating. This feature of the core/shell structure cannot be proved by the method defined as shell coating by each Patent Literature and each Non-Patent Literature. On the other hand, the quantum dot of the present embodiment is a crystallized quantum dot in which Ag, Ga, or Se is clearly separated in the core, and Zn or S is clearly separated in the shell. Even after the shell coating, the XRD peak position changes similarly to the conventional quantum dot. Therefore, the quantum dot of the present embodiment is the first quantum dot in which the clear shell coating can be realized.

Furthermore, in the present embodiment, the single core has high emission intensity, and the fluorescence full width at half maximum can be narrowed and the band edge emission can be confirmed even without the core/shell structure.

In the present embodiment, the fluorescence wavelength can be controlled from green to red by appropriately adjusting the particle size of the quantum dots 5 and the composition of the quantum dots 5. Therefore, the fluorescence wavelength is preferably 500 nm or more and 560 nm or less, more preferably 510 nm or more and 550 nm or less, and still more preferably 520 nm or more and 540 nm or less for green emission. For red emission, the fluorescence wavelength is preferably 600 nm or more and 660 nm or less, more preferably 610 nm or more and 650 nm or less, and still more preferably 620 nm or more and 640 nm or less.

In the present embodiment, as described above, the fluorescence wavelength can be adjusted within a range of 500 nm or more and 700 nm or less.

The quantum dots 5 of the present embodiment exhibit fluorescence characteristics in which the fluorescence full width at half maximum is 35 nm or less and the fluorescence quantum yield is 70% or more.

Here, the "fluorescence full width at half maximum" refers to a full width at half maximum indicating the spread of the fluorescence wavelength at half of the peak value of the fluorescence intensity in the fluorescence spectrum. The fluorescence full width at half maximum is preferably 35 nm or less. Further, the fluorescence full width at half maximum is more preferably 30 nm or less. As described above, since the fluorescence full width at half maximum can be narrowed, it is possible to improve the high color gamut.

The fluorescence quantum yield of the quantum dot 5 of the present embodiment is preferably 70% or more, and more preferably 80% or more. It is more preferable that the fluorescence quantum yield is 90% or more. As described above, in the present embodiment, the fluorescence quantum yield of the quantum dot can be increased.

Chalcopyrite was generally a defect light-emitting material having a fluorescence full width at half maximum of 70 to 100 nm. On the other hand, the quantum dot 5 of the present embodiment has a narrow fluorescence full width at half maximum, has a high fluorescence quantum yield, and can have a fluorescence lifetime much shorter than that of defect emission. From such characteristics, it is presumed that the quantum dots 5 of the present embodiment perform band edge emission.

In the above-described method for manufacturing quantum dots of the present embodiment, Cu can be added when an AgGaSe core or an AgGaS core is produced.

An organic copper compound or an inorganic copper compound is used as a raw material of Cu. Although not particularly limited, for example, copper acetate: Cu(OAc)₂ or copper nitrate: Cu(NO₃)₂, can be used, copper chloride: CuCl₂, copper bromide: CuBr₂, or silver iodide: CuI₂ can be used as halides, copper diethyldithiocarbamate: Cu(SC( = S)N(C₂H₅)₂)₂, copper dimethyldithiocarbamate: Cu(SC( = S)N(CH₃)₂)₂, or the like can be used as carbamates.

In the present embodiment, the Cu raw material described above may be directly added to the reaction solution, or a solution prepared by dissolving the Cu raw material in an organic solvent in advance to have a constant concentration may be used as the Cu raw material solution.

It is considered that Cu acts as a catalyst during core production. That is, from the results of TEM-EDX analysis, it is difficult to quantify Cu, and even in XRD, equivalent results are obtained regardless of the presence or absence of Cu addition. Therefore, it is presumed that Cu acts as a catalyst rather than being solid-solved in the elements constituting the core.

At the time of core production, addition of Cu makes it possible to increase the quantum yield (QY) to be equal to or more than that in a case where Cu is not added, and to reduce the fluorescence full width at half maximum to be equal to or less than that in a case where Cu is not added. Depending on the application to which the quantum dot is applied, a better result can be obtained by adding Cu. The application of the quantum dot 5 illustrated in Fig. 1 is not particularly limited, but some specific examples will be described below.

Fig. 2 is a schematic diagram of an LED device using the quantum dots of the present embodiment. As illustrated in Fig. 2, the LED device 1 of the present embodiment includes a storage case 2 having a bottom surface 2a and a side wall 2b surrounding the periphery of the bottom surface 2a, an LED chip (light emitting element) 3 disposed on the bottom surface 2a of the storage case 2, and a fluorescent layer 4 filling the storage case 2 and sealing the upper surface side of the LED chip 3. Here, the upper surface side is a direction in which light emitted from the LED chip 3 is emitted from the storage case 2, and indicates a direction opposite to the bottom surface 2a with respect to the LED chip 3.

The LED chip 3 may be disposed on a base wiring board (not illustrated), and the base wiring board may constitute a bottom surface portion of the storage case 2. As the base substrate, for example, a configuration in which a wiring pattern is formed on a base material such as glass epoxy resin can be presented.

The LED chip 3 is a semiconductor element that emits light when a voltage is applied in the forward direction, and has a basic configuration in which a P-type semiconductor layer and an N-type semiconductor layer are PN bonded. As shown in Fig. 2, the fluorescent layer 4 is formed of a resin 6 in which a large number of quantum dots 5 are dispersed.

The resin composition in which the quantum dots 5 are dispersed in the present embodiment may contain the quantum dots 5 and a fluorescent substance different from the quantum dots 5. Examples of the fluorescent substance include sialon-based fluorescent substances and KSF (K₂SiF₆: Mn⁴⁺) red fluorescent substances, but the material thereof is not particularly limited.

The resin 6 constituting the fluorescent layer 4 is not particularly limited, but polypropylene (PP), polystyrene (PS), acrylic resin, methacrylate, MS resin, polyvinyl chloride (PVC), polycarbonate (PC), polyethylene terephthalate (PET), polyethylene naphthalate (PEN), polymethylpentene, liquid crystal polymer, epoxy resin, silicone resin, or a mixture thereof can be used.

The LED device using the quantum dots of the present embodiment can be applied to a display device. Fig. 3 is a longitudinal sectional view of a display device using the LED device illustrated in Fig. 2. As illustrated in Fig. 3, a display device 50 includes a plurality of LED devices 20 and a display unit 54 such as a liquid crystal display facing each LED device 20. Each LED device 20 is arranged on the back surface side of the display unit 54. Similarly to the LED device 1 illustrated in Fig. 2, each LED device 20 has a structure in which an LED chip is sealed with a resin obtained by diffusing a large number of quantum dots 5.

As illustrated in Fig. 3, the plurality of LED devices 20 are supported by a support 52. The LED devices 20 are arranged at predetermined intervals. Each LED device 20 and the support 52 constitute a backlight 55 for the display unit 54. The support 52 has a sheet shape, a plate shape, a case shape, or the like, and is not particularly limited in shape or material. As illustrated in Fig. 3, a light diffusion plate 53 or the like may be interposed between the backlight 55 and the display unit 54.

By applying the quantum dot 5 having a narrow fluorescence full width at half maximum in the present embodiment to the LED device shown in Fig. 2, the display device shown in Fig. 3, and the like, the emission characteristics of the device can be effectively improved.

A resin composition in which the quantum dots 5 of the present embodiment are dispersed in a resin can also be formed into a sheet shape or a film shape. Such a sheet or film can be incorporated into, for example, a backlight device.

### Examples

Hereinafter, effects of the present invention will be described with reference to Examples and Comparative Examples of the present invention. Note that the present invention is not limited by the following Examples at all.

### <Raw material>

In the experiment, the following raw materials were used to synthesize quantum dots having a core/shell structure of AgGaSe/ZnS.
(Solvent)
   Oleylamine: manufactured by Kao Corporation
   Dodecanethiol: manufactured by Kao Corporation
(Silver raw material)
   Silver acetate: manufactured by Aldrich Co., Ltd.
(Gallium raw material)
   Gallium acetylacetonate: manufactured by Tokyo Chemical Industry Co., Ltd.
(Selenium)
   Selenium: Shinko Chemical Industrial Co., Ltd.
(Zinc)
   Zinc acetate: manufactured by Kishida Chemical Co., Ltd.
   Zinc bromide: manufactured by Kishida Chemical Co., Ltd.
(Sulfur raw material)
   Sulfur: manufactured by Kishida Chemical Co., Ltd.

### <Measuring instrument>

Fluorescence spectrometer: F-2700 manufactured by JASCO Corporation
Quantum yield measurement device: QE-1100 manufactured by Otsuka Electronics Co., Ltd.
Scanning electron microscope (SEM): SU 9000 manufactured by Hitachi, Ltd.
X-ray diffractometer (XRD): D2 PHASER manufactured by Bruker Corporation

### [Example 1]

A 100 mL reaction vessel was charged with 0.5 ml of a 0.2M solution obtained by dissolving silver acetate: Ag(OAc) in oleylamine: OLAm, 36.7 mg of gallium acetylacetonate: Ga(acac)₃, 20.0 mL of oleylamine: OLAm, and 2.0 ml of dodecanethiol: DDT. Then, heating was performed while stirring under an inert gas (N₂) atmosphere to dissolve the raw materials.

This solution was dissolved at 150°C for 10 minutes, and 0.3 ml of a 0.7M solution obtained by dissolving selenium and Se in a mixed solvent of dodecanethiol: DDT and oleylamine: OLAm at a volume ratio of 5:2 was added thereto. Thereafter, the temperature was raised from 150°C to 320°C, and the mixture was stirred for a total of 10 minutes. Thereafter, the obtained reaction solution was cooled to room temperature.

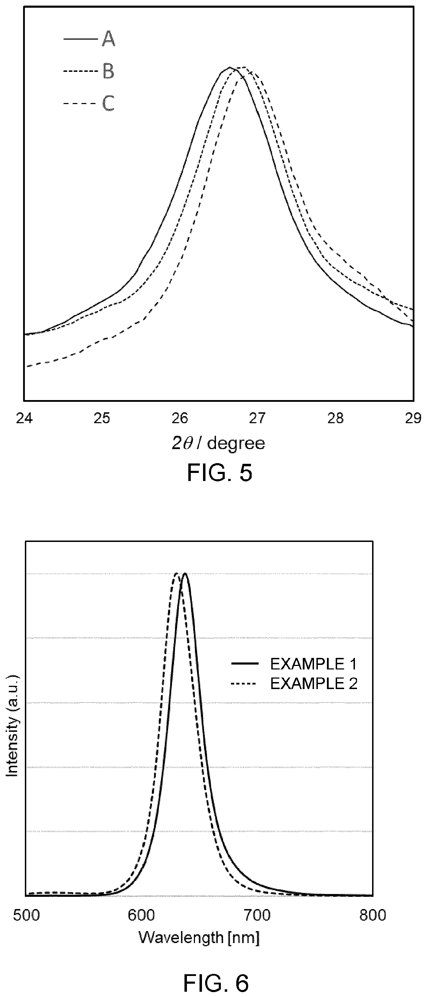

The resulting reaction solution was centrifuged at 5500 rpm for 3 minutes to obtain a precipitate. The precipitate was re-dispersed with toluene, ethanol was added, and then centrifuged at 7500 rpm for 3 minutes to obtain a precipitate. The precipitate was then re-dispersed in 10.0 ml of dodecanethiol: DDT. The precipitate obtained here was measured using an X-ray diffraction (XRD) apparatus. The results are shown as A in Fig. 5.

This dispersion was placed in a 100 mL reaction vessel, heated at 270°C for 10 minutes under an inert gas (N₂) atmosphere, and 0.15 ml of a 0.4M solution obtained by dissolving sulfur: S in dodecanethiol: DDT and 0.2 ml of a 0.1M solution obtained by dissolving gallium acetylacetonate: Ga(acac)₃ in oleyl alcohol: OLOH were added dropwise 5 times every 10 minutes. Thereafter, the obtained reaction solution was cooled to room temperature.

Toluene and ethanol were added to the obtained reaction solution, and then the mixture was centrifuged at 7500 rpm for 3 minutes to obtain a precipitate. The precipitate was then re-dispersed in 10.0 ml of dodecanethiol: DDT. The precipitate obtained here was measured using an X-ray diffraction (XRD) apparatus. The results are shown as B in Fig. 5.

This dispersion was placed in a 100 mL reaction vessel, heated at 180°C for 10 minutes under an inert gas (N₂) atmosphere, and 0.1 ml of a 0.2M solution obtained by dissolving zinc bromide: ZnBr₂ in dodecanethiol: DDT and 0.1 ml of a 0.4M solution obtained by dissolving sulfur: S in dodecanethiol: DDT were alternately added dropwise 5 times every 10 minutes. Thereafter, the obtained reaction solution was cooled to room temperature.

### <Experiment of fluorescence full width at half maximum and quantum yield>

The QD dispersion solution was measured with a fluorescence spectrometer and a quantum efficiency measurement system. As a result, as shown in Fig. 6, optical characteristics were obtained in which the fluorescence wavelength was 637.5 nm, the fluorescence full width at half maximum was 32.11 nm, and the quantum yield was 76%. The precipitate obtained here was measured using an X-ray diffraction (XRD) apparatus. The results are shown as C in Fig. 5.

### <Analysis Result of X-ray Diffraction (XRD) Device>

Fig. 5 shows the maximum peaks of the results of analyzing samples A, B, and C obtained in each synthesis process with an XRD apparatus. From this result, it was confirmed that the XRD peak was shifted to the high angle side from A to B. In this synthesis process, a sample obtained by adding Ga and S to AgGaSe₂ (A sample) obtained as a core is B. In addition, a sample obtained by adding Zn and S to the sample B obtained here is C. Also in this synthesis process, it was confirmed that the XRD peak was further shifted to the higher angle side from B to C. Considering from such a peak shift, it can be presumed that Ag contained in the core does not diffuse into the shell and can coat the shell containing a large amount of Zn.

### <Analysis Results of TEM-EDX>

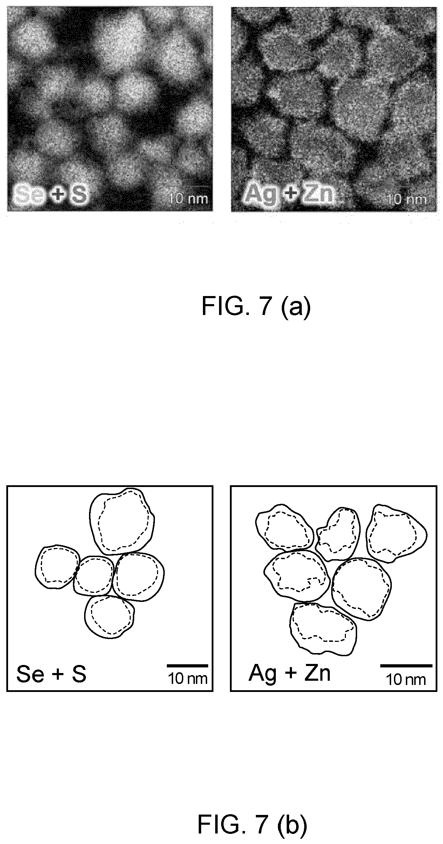

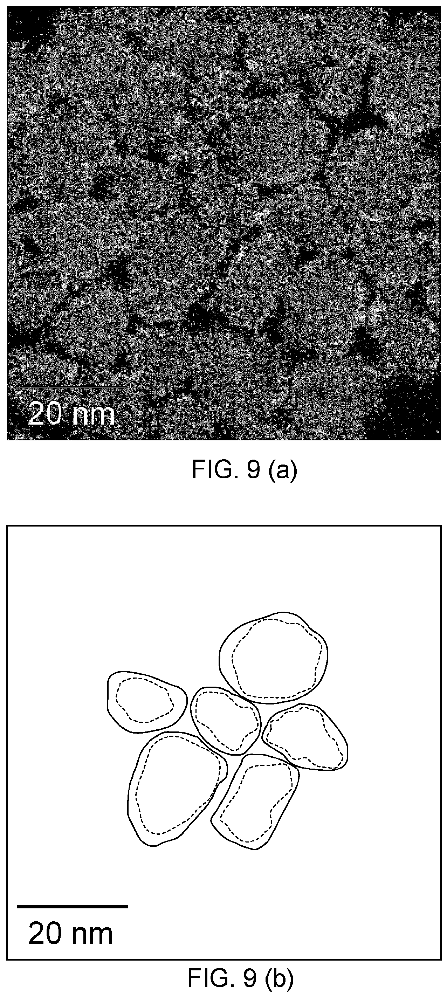

A result (observation image) of analyzing the quantum dot of Example 1 by TEM-EDX is shown in Fig. 7. Fig. 7(a) is a photograph of the analysis results (Se + S and Ag + Zn) of TEM-EDX, and Fig. 7(b) is a partial schematic view of Fig. 7(a). The dotted line in Fig. 7(b) indicates the vicinity of the boundary between the core and the shell (does not indicate a clear boundary). The same applies to Fig. 9 and the subsequent drawings. The observation image on the left side of Fig. 7 is an analysis result of Se + S, and the observation image on the right side of Fig. 7 is an analysis result of Ag + Zn. From this experimental result, it was found that Se and S were separately present, and specifically, S was present around Se. In addition, it was found that Ag and Zn were separately present, and specifically, Zn was present around Ag. Se and Ag are mainly contained in the core, and S and Zn are mainly contained in the shell. However, it has been found that the components contained in the core can be suppressed from diffusing into the shell, and similarly, the components contained in the shell can be suppressed from diffusing into the core.

### [Example 2]

According to the same manufacturing operation as in Example 1, the same operation was performed up to the GaS coating, and the operation of post-adding Zn to the obtained particles was performed nine times. The quantum dot dispersion solution was measured with a fluorescence spectrometer and a quantum efficiency measurement system. As a result, as shown in Fig. 6, optical characteristics were obtained in which the fluorescence wavelength was 630 nm, the fluorescence full width at half maximum was 34 nm, and the maximum quantum yield was 94%.

### <High-Resolution STEM Result>

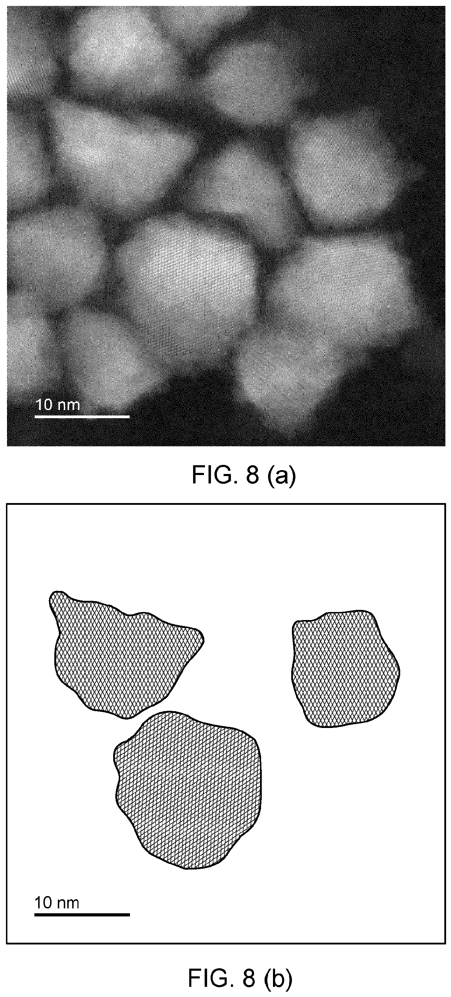

Fig. 8 shows the results of analyzing the quantum dots of Example 2 by high-resolution STEM. Fig. 8(a) is a photograph of an analysis result of high-resolution STEM in Example 2, and Fig. 8(b) is a partial schematic view of Fig. 8 (a). When the particles in Fig. 8 were confirmed, a crystal lattice was confirmed from the entire particles. From this result, it can be presumed that the shell is crystallized, and it is considered that diffusion of Ag contained in the core and the amount of Zn contained in the shell is suppressed.

### <Analysis Results of TEM-EDX>

A result (observation image) of analyzing the quantum dots of Experimental Example 2 by TEM-EDX is shown in Fig. 9. Fig. 9(a) is a photograph of the analysis result (Ag + Zn) of TEM-EDX in Example 2, and Fig. 9(b) is a partial schematic view of Fig. 9(a). The observation image of Fig. 9 is an analysis result of Ag + Zn. From this observation image, it has been found that Zn was present around Ag, and diffusion of components contained in the core into the shell can be suppressed, and similarly, diffusion of components contained in the shell into the core can be suppressed.

### <Measurement result of Zn amount>

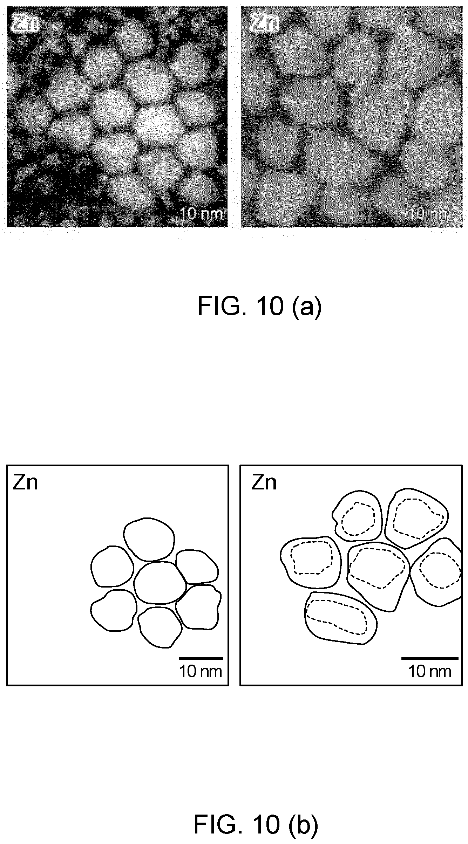

Fig. 10 shows the results of analyzing the amount of Zn by TEM-EDX. Fig. 10(a) is a photograph of the analysis result (Zn) of TEM-EDX in Example 1 and Comparative Example, and Fig. 10(b) is a partial schematic view of Fig. 10(a). The observation image on the left side of Fig. 10 is Comparative Example 1, and the observation image on the right side of Fig. 10 is Example 1. In Comparative Example 1, unlike the above experimental example, the shell of the first layer was coated with an oleylamine solvent in the step of the center diagram of Fig. 4, and Zn was post-added in the step of the right diagram of Fig. 4. On the other hand, the example is Experimental Example 1 described above, that is, quantum dots were produced through the manufacturing step shown in Fig. 4.

From the experimental results shown in Fig. 10, it was confirmed that the amount of Zn contained in the surface of the core in Example 1 was larger than that in Comparative Example 1, and the surface of AgGaSe was appropriately coated with GaS and ZnS.

The amount of Zn contained in the quantum dots of Comparative Example 1, Example 1, and Example 2 was measured to be about 1% in Comparative Example 1, about 5% in Example 1, and about 10% in Example 2. It was found that the amount of Zn in Examples 1 and 2 was several times to about 10 times larger than that in Comparative Example 1. In Example 2, the amount of Zn was about twice as large as that in Example 1. This is because the number of Zn post-addition steps was increased in Example 2.

### [Example 3]

A 100 mL reaction vessel was charged with 1.8 ml of a 0.2M solution obtained by dissolving silver acetate: Ag(OAc) in oleylamine: OLAm, 0.2 ml of a 0.2M solution obtained by dissolving copper acetate: Cu(OAc)₂ in oleylamine: OLAm, 0.2644 mg of gallium acetylacetonate: Ga(acac)₃, 20.0 mL of oleylamine: OLAm, and 4.0 ml of dodecanethiol: DDT. Then, heating was performed while stirring under an inert gas (N₂) atmosphere to dissolve the raw materials.

This solution was dissolved at 150°C for 10 minutes, and 1.43 ml of a 0.7M solution obtained by dissolving selenium and Se in a mixed solvent of dodecanethiol: DDT and oleylamine: OLAm at a volume ratio of 5:2 was added thereto. Thereafter, the temperature was raised from 150°C to 320°C, and the mixture was stirred for a total of 20 minutes. Thereafter, the obtained reaction solution was cooled to room temperature.

The resulting reaction solution was centrifuged at 5500 rpm for 3 minutes to obtain a precipitate. The precipitate was re-dispersed with toluene, ethanol was added, and then centrifuged at 7500 rpm for 3 minutes to obtain a precipitate. The precipitate was then re-dispersed in 10.0 ml of dodecanethiol: DDT.

This dispersion was placed in a 100 mL reaction vessel, and heated at 270°C for 5 minutes under an inert gas (N₂) atmosphere, and 0.25 ml of a 0.8M solution obtained by dissolving sulfur: S in dodecanethiol: DDT and 1.3 ml of a 0.1M solution obtained by dissolving gallium acetylacetonate: Ga(acac)₃ in oleyl alcohol: OLOH were mixed. Heating was performed for a total of 60 minutes. Thereafter, the obtained reaction solution was cooled to room temperature.

Toluene and ethanol were added to the obtained reaction solution, and then the mixture was centrifuged at 7500 rpm for 3 minutes to obtain a precipitate. The precipitate was then re-dispersed in 10.0 ml of dodecanethiol: DDT.

This dispersion was placed in a 100 mL reaction vessel, heated at 200°C for 5 minutes under an inert gas (N₂) atmosphere, 2.0 ml of a 0.8M solution obtained by dissolving zinc bromide: ZnBr₂ in dodecanethiol: DDT and 2.0 ml of a 0.8M solution obtained by dissolving sulfur: S in dodecanethiol: DDT were mixed, and 0.4 ml of each solution was added dropwise every 10 minutes. Heating was performed for a total of 120 minutes. The resulting reaction solution was cooled to room temperature.

The QD dispersion solution was measured with a fluorescence spectrometer. As a result, optical characteristics were obtained in which the fluorescence wavelength was 623.5 nm, the fluorescence full width at half maximum was 34.70 nm, and the quantum yield was 76%.

### [Example 4]

A 300 mL reaction vessel was charged with 5.4 ml of a 0.2M solution obtained by dissolving silver acetate: Ag(OAc) in oleylamine: OLAm, 0.88092 g of gallium acetylacetonate: Ga(acac)₃, 120.0 mL of oleylamine: OLAm, and 11 ml of dodecanethiol: DDT. Then, heating was performed while stirring under an inert gas (N₂) atmosphere to dissolve the raw materials.

This solution was dissolved at 150°C for 15 minutes, and 4.29 ml of a 0.7M solution obtained by dissolving selenium and Se in a mixed solvent of dodecanethiol: DDT and oleylamine: OLAm at a volume ratio of 5:2 was added thereto. Thereafter, the temperature was raised from 150°C to 320°C, and the mixture was stirred for a total of 25 minutes. Thereafter, the obtained reaction solution was cooled to room temperature.

The resulting reaction solution was centrifuged at 5500 rpm for 3 minutes to obtain a precipitate. The precipitate was re-dispersed with toluene, ethanol was added, and then centrifuged at 7500 rpm for 3 minutes to obtain a precipitate. Again, the precipitate was re-dispersed with toluene, ethanol was added, and then centrifuged at 7500 rpm for 3 minutes to obtain a precipitate. The precipitate was then re-dispersed in 60.0 ml of dodecanethiol: DDT.

This dispersion was placed in a 300 mL reaction vessel, and heated at 270°C for 5 minutes under an inert gas (N₂) atmosphere, and 0.1 ml of a 0.8M solution obtained by dissolving sulfur: S in dodecanethiol: DDT was mixed and heated for 20 minutes. Thereafter, 1.2 ml of a 0.8M solution obtained by dissolving sulfur: S in dodecanethiol: DDT and 6.01 of a 0.1M solution obtained by dissolving gallium acetylacetonate: Ga(acac)₃ in oleyl alcohol: OLOH were mixed, and each 1.44 ml was added dropwise 5 times every 10 minutes. Heating was performed for a total of 50 minutes. Thereafter, the obtained reaction solution was cooled to room temperature.

Toluene, ethanol, and methanol were added to the obtained reaction solution, and then centrifuged at 7500 rpm for 3 minutes to obtain a precipitate. Thereafter, the precipitate was re-dispersed in 87.5 ml of octadecene: ODE and 10 ml of trioctylphosphine: TOP.

This dispersion was placed in a 300 mL reaction vessel, heated at 240°C for 5 minutes under an inert gas (N₂) atmosphere, and 10 ml of a 0.8M solution obtained by dissolving zinc acetate: Zn(OAc)₂ in trioctylphosphine: TOP and oleic acid: OLAc at a volume ratio of 1:1, 6.7 ml of octadecene: ODE, 2.3 ml of trioctylphosphine: TOP, 1.0 ml of dodecanethiol: DDT, and 0.4 ml of a 4N solution obtained by dissolving hydrogen chloride: HCl in ethyl acetate: C₄H₈O₂ were mixed, and the mixture was added dropwise 8 times every 10 minutes by 2.25 ml. Heating was performed for a total of 80 minutes. The resulting reaction solution was cooled to room temperature.

The QD dispersion solution was measured with a fluorescence spectrometer. As a result, optical characteristics were obtained in which the fluorescence wavelength was 622.5 nm, the fluorescence full width at half maximum was 36.1 nm, and the quantum yield was 91%.

### [Example 5]

A 100 mL reaction vessel was charged with 0.45 ml of a 0.2M solution obtained by dissolving silver acetate: Ag(OAc) in oleylamine: OLAm, 0.0734 g of gallium acetylacetonate: Ga(acac)₃, 10.0 mL of oleylamine: OLAm, 0.917 ml of dodecanethiol: DDT, and 0.0643 ml of a 0.7M solution obtained by dissolving selenium: Se in a mixed solvent of dodecanethiol: DDT and oleylamine: OLAm at a volume ratio of 1:1. Then, heating was performed while stirring under an inert gas (N₂) atmosphere to dissolve the raw materials.

This solution was dissolved at 320°C for 1.25 minutes, and 1 ml of a 0.8M solution obtained by dissolving sulfur: S in dodecanethiol: DDT was mixed thereon and heated for 60 minutes. Thereafter, the obtained reaction solution was cooled to room temperature.

Toluene and ethanol were added to the obtained reaction solution, and then the mixture was centrifuged at 7500 rpm for 3 minutes to obtain a precipitate. The precipitate was re-dispersed with toluene, ethanol was added, and then centrifuged at 7500 rpm for 3 minutes to obtain a precipitate. The precipitate was then re-dispersed in 5.0 ml of dodecanethiol: DDT. Centrifugation was performed at 5500 rpm for 3 minutes to obtain a precipitate.

This dispersion was placed in a 100 mL reaction vessel, heated at 240°C for 3 minutes under an inert gas (N₂) atmosphere, 2 ml of a 0.2M solution obtained by dissolving zinc bromide: ZnBr₂ in dodecanethiol: DDT and 0.53 ml of trioctylphosphine: TOP were mixed, and 0.506 ml of each solution was added dropwise 3 times every 10 minutes. Heating was performed for a total of 30 minutes. The resulting reaction solution was cooled to room temperature.

The QD dispersion solution was measured with a fluorescence spectrometer. As a result, optical characteristics were obtained in which the fluorescence wavelength was 540.5 nm and the fluorescence full width at half maximum was 39.0 nm.

### [Comparative Example 2]

A 100 mL reaction vessel was charged with 1.8 ml of a 0.2M solution obtained by dissolving silver acetate: Ag(OAc) in oleylamine: OLAm, 0.2 ml of a 0.2M solution obtained by dissolving copper acetate: Cu(OAc)₂ in oleylamine: OLAm, 0.2644 mg of gallium acetylacetonate: Ga(acac)₃, 20.0 mL of oleylamine: OLAm, and 4.0 ml of dodecanethiol: DDT. Then, heating was performed while stirring under an inert gas (N₂) atmosphere to dissolve the raw materials.

This solution was dissolved at 150°C for 10 minutes, and 1.43 ml of a 0.7M solution obtained by dissolving selenium and Se in a mixed solvent of dodecanethiol: DDT and oleylamine: OLAm at a volume ratio of 5:2 was added thereto. Thereafter, the temperature was raised from 150°C to 320°C, and the mixture was stirred for a total of 20 minutes. Thereafter, the obtained reaction solution was cooled to room temperature.

The resulting reaction solution was centrifuged at 5500 rpm for 3 minutes to obtain a precipitate. The precipitate was re-dispersed with toluene, ethanol was added, and then centrifuged at 7500 rpm for 3 minutes to obtain a precipitate. The precipitate was then re-dispersed in 10.0 ml of dodecanethiol: DDT.

This dispersion was placed in a 100 mL reaction vessel, and heated at 270°C for 5 minutes under an inert gas (N₂) atmosphere, and 0.25 ml of a 0.8M solution obtained by dissolving sulfur: S in dodecanethiol: DDT was mixed. After heating for 20 minutes, the resulting reaction solution was cooled to room temperature.

Hexane and ethanol were added to the obtained reaction solution, and then the mixture was centrifuged at 7500 rpm for 3 minutes to obtain a precipitate. The precipitate was then re-dispersed in 10.0 ml of dodecanethiol: DDT.

This dispersion was placed in a 100 mL reaction vessel, heated at 200°C for 5 minutes under an inert gas (N₂) atmosphere, 2.0 ml of a 0.8M solution obtained by dissolving zinc bromide: ZnBr₂ in dodecanethiol: DDT and 2.0 ml of a 0.8M solution obtained by dissolving sulfur: S in dodecanethiol: DDT were mixed, and 0.4 ml of each solution was added dropwise every 10 minutes. Heating was performed for a total of 120 minutes. The resulting reaction solution was cooled to room temperature.

The QD dispersion solution was measured with a fluorescence spectrometer. As a result, optical characteristics were obtained in which the fluorescence wavelength was 631.0 nm, the fluorescence full width at half maximum was 36.24 nm, and the quantum yield was 96%.

### <Quantum dots in which shell is formed by cation exchange>

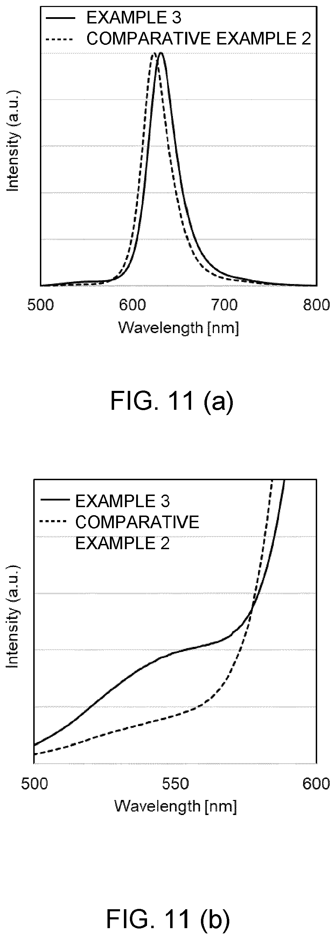

Example 3 is an experimental example in which GaS coating was performed, and Comparative Example 2 is an experimental example in which GaS coating was not performed. Figs. 11(a) and 11(b) are photoluminescence (PL) spectra in Example 3 and Comparative Example 2. Fig. 11(b) is an enlarged view of a part of Fig. 11(a).

As shown in Fig. 11(b), in Comparative Example 2, an emission spectrum was confirmed in the vicinity of a short wavelength of 500 to 550 nm as compared with Example 3. This is presumed to be because Zn was subjected to cation exchange with Ag, Cu, Ga, or the like as cation species of the core when a ZnS raw material as a shell was added because GaS coating was not performed in Comparative Example 2.

On the other hand, in Example 3, it was found that by adding a ZnS raw material after GaS coating, short-wavelength emission can be suppressed as compared with Comparative Example 2.

Therefore, it is presumed that Zn added later does not diffuse into the core due to the coating GaS.

From the above experimental results, it is considered that Ga and Zn after GsS coating are changed to ZnS by cation exchange. In addition, since the particle sizes of the AgGaSe/GaS particles and the AgGaSe/ZnS particles hardly change, it is presumed that Ga and Zn are cation-exchanged or anion-solid-solved.

### <Band emission of core>

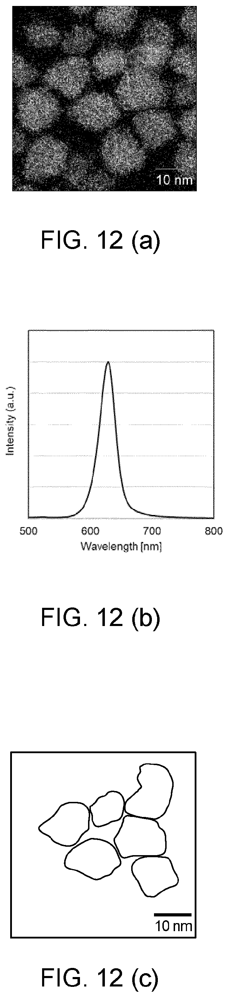

The core of Example 3 was subjected to EDX analysis. The experimental results are shown in Fig. 12(a). Fig. 12(c) is a partial schematic diagram of Fig. 12(a). As illustrated in Fig. 12(a), it was found that Ga (blue) and Ag (purple) were present in almost the same distribution in the core. From this, it is considered that the core/shell structure is not formed. Fig. 12(b) is a photoluminescence (PL) spectrum of the core of Example 3. As shown in Fig. 12(b), it was found that the fluorescence full width at half maximum of the emission spectrum was narrow.

In the present example, it was found that band emission occurred even in the single core.

### <Catalysis of Cu>

In Example 3, Cu was added at the time of producing the core, but it was difficult to accurately quantify Cu from the results of TEM-EDX analysis. Also in XRD, the same results were obtained regardless of the presence or absence of Cu addition. Therefore, it is presumed that Cu acts as a catalyst rather than being solid-solved in the elements constituting the core.

### Industrial Applicability

According to the present invention, for example, a quantum dot showing high-luminance green fluorescence or red fluorescence can be stably obtained. By applying the quantum dot of the present invention to an LED, a backlight device, a display device, or the like, excellent emission characteristics can be obtained in each device.

## Claims

1. A method for manufacturing quantum dots, comprising:
a step of producing a core containing at least Ag, Ga, and S or Ag, Ga, and Se; and
a step of coating a surface of the core with a shell, wherein
in the step of coating with the shell,
the surface of the core is coated with GaS, wherein the surface of the core is coated with an organozinc compound or an inorganic zinc compound after being coated with GaS.

2. The method for manufacturing quantum dots according to claim 1, wherein after coating with GaS, Ga and Zn are subjected to cation exchange to form ZnS.

3. The method for manufacturing quantum dots according to claim 1 or 2, wherein Cu is added when the core is produced.

4. The method for manufacturing quantum dots according to any one of claims 1 to 3, wherein the core and the shell do not contain Cd and In.

5. The method for manufacturing quantum dots according to any one of claims 1 to 4, wherein gallium acetylacetonate (Ga(acac)₃) is used as a Ga raw material.

6. The method for manufacturing quantum dots according to any one of claims 1 to 5, wherein the core contains Cu.

7. A quantum dot comprising:
a core containing at least Ag, Ga, and S or Ag, Ga, and Se; and
a shell coating a surface of the core, wherein
GaS or GaSe is interposed between the core and the shell,
the shell is made of ZnS, and
the quantum dot exhibits fluorescence characteristics with a fluorescence full width at half maximum of 35 nm or less and a fluorescence quantum yield of 70% or more.

8. The quantum dot according to claim 7, wherein the core and the shell do not contain Cd and In.

9. The quantum dot according to claim 7 or 8, wherein a fluorescence wavelength is in a range of 400 nm or more and 700 nm or less.

10. The quantum dot according to any one of claims 7 to 8, wherein a single core exhibits band edge emission.

11. The quantum dot according to any one of claims 7 to 10, wherein the core contains Cu.

## Patentansprüche

1. Verfahren zur Herstellung von Quantenpunkten, umfassend:
einen Schritt des Herstellens eines Kerns, der mindestens Ag, Ga und S oder Ag, Ga und Se enthält; und
einen Schritt des Beschichtens einer Oberfläche des Kerns mit einer Hülle, wobei
in dem Schritt des Beschichtens mit der Hülle
die Oberfläche des Kerns mit GaS beschichtet wird, wobei die Oberfläche des Kerns nach dem Beschichten mit GaS mit einer Organozinkverbindung oder einer anorganischen Zinkverbindung beschichtet wird.

2. Verfahren zur Herstellung von Quantenpunkten gemäß Anspruch 1, wobei nach dem Beschichten mit GaS, Ga und Zn einem Kationenaustausch unterzogen werden, um ZnS zu bilden.

3. Verfahren zur Herstellung von Quantenpunkten gemäß Anspruch 1 oder 2, wobei Cu hinzugefügt wird, wenn der Kern hergestellt wird.

4. Verfahren zur Herstellung von Quantenpunkten gemäß einem der Ansprüche 1 bis 3, wobei der Kern und die Hülle kein Cd und kein In enthalten.

5. Verfahren zur Herstellung von Quantenpunkten gemäß einem der Ansprüche 1 bis 4, wobei Galliumacetylacetonat (Ga(acac)₃) als Ga-Rohmaterial verwendet wird.

6. Verfahren zur Herstellung von Quantenpunkten gemäß einem der Ansprüche 1 bis 5, wobei der Kern Cu enthält.

7. Quantenpunkt, umfassend:
einen Kern, der mindestens Ag, Ga und S oder Ag, Ga und Se enthält; und
eine Hülle, die eine Oberfläche des Kerns umhüllt, wobei
GaS oder GaSe zwischen dem Kern und der Hülle angeordnet ist,
die Hülle aus ZnS besteht und
der Quantenpunkt Fluoreszenzeigenschaften mit einer Halbwertsbreite der Fluoreszenz von 35 nm oder weniger und einer Fluoreszenzquantenausbeute von 70 % oder mehr aufweist.

8. Quantenpunkt gemäß Anspruch 7, wobei der Kern und die Hülle kein Cd und kein In enthalten.

9. Quantenpunkt gemäß Anspruch 7 oder 8, wobei eine Fluoreszenzwellenlänge in einem Bereich von 400 nm oder mehr und 700 nm oder weniger liegt.

10. Quantenpunkt gemäß einem der Ansprüche 7 bis 8, wobei ein einzelner Kern eine Bandkantenemission aufweist.

11. Quantenpunkt gemäß einem der Ansprüche 7 bis 10, wobei der Kern Cu enthält.

## Revendications

1. Procédé de fabrication de points quantiques, comprenant :
une étape de production d'un noyau contenant au moins Ag, Ga et S, ou Ag, Ga et Se, et
une étape de revêtement d'une surface du noyau avec une enveloppe ; et dans lequel
dans l'étape de revêtement avec l'enveloppe,
la surface du noyau est revêtue de GaS, ladite surface du noyau étant revêtue d'un composé à base d'organozinc ou d'un composé à base de zinc inorganique après avoir été revêtue de GaS.

2. Procédé de fabrication de points quantiques selon la revendication 1, dans lequel, après le revêtement de GaS, le Ga et le Zn sont soumis à un échange cationique afin de former du ZnS.

3. Procédé de fabrication de points quantiques selon la revendication 1 ou 2, dans lequel du Cu est ajouté lors de la production du noyau.

4. Procédé de fabrication de points quantiques selon l'une quelconque des revendications 1 à 3, dans lequel le noyau et l'enveloppe ne contiennent ni Cd ni In.

5. Procédé de fabrication de points quantiques selon l'une quelconque des revendications 1 à 4, dans lequel de l'acétylacétonate de gallium (Ga(acac)₃) est utilisé comme matière première à base de Ga.

6. Procédé de fabrication de points quantiques selon l'une quelconque des revendications 1 à 5, dans lequel le noyau contient du Cu.

7. Point quantique comprenant :
un noyau contenant au moins Ag, Ga et S, ou Ag, Ga et Se, et
une enveloppe recouvrant une surface du noyau ; et dans lequel
du GaS ou GaSe est intercalé entre le noyau et l'enveloppe,
l'enveloppe est constituée de ZnS, et
le point quantique présente des caractéristiques de fluorescence avec une largeur maximale à mi-hauteur de fluorescence inférieure ou égale à 35 nm et un rendement quantique de fluorescence supérieur ou égal à 70 %.

8. Point quantique selon la revendication 7, dans lequel le noyau et l'enveloppe ne contiennent ni Cd ni In.

9. Point quantique selon la revendication 7 ou 8, dans lequel la longueur d'onde de fluorescence se situe dans une plage supérieure ou égale à 400 nm et inférieure ou égale à 700 nm.

10. Point quantique selon l'une quelconque des revendications 7 à 8, dans lequel un seul noyau présente une émission en bord de bande.

11. Point quantique selon l'une quelconque des revendications 7 à 10, dans lequel le noyau contient du Cu.
